# FASCICULE DE BREVET EUROPEEN

(11) **EP 2 304 450 B1**
(45) Date de publication et mention de la délivrance du brevet: **21.03.2018**
(21) Numéro de dépôt: 09797454.7
(22) Date de dépôt: 23.06.2009
(51) Int. Cl.: G01R 29/08

(54) **PERFECTIONNEMENTS À LA DÉTERMINATION D'AU MOINS UNE GRANDEUR ASSOCIÉE AU RAYONNEMENT ÉLECTROMAGNÉTIQUE D'UN OBJET SOUS TEST**
VERBESSERUNGEN BEI DER BESTIMMUNG MINDESTENS EINES MIT DER ELEKTROMAGNETISCHEN STRAHLUNG EINES GETESTETEN OBJEKTS ASSOZIIERTEN WERTES
IMPROVEMENTS IN THE DETERMINATION OF AT LEAST ONE VALUE ASSOCIATED WITH THE ELECTROMAGNETIC RADIATION OF AN OBJECT BEING TESTED

(30) Priorité: 23.06.2008 FR 0854138
(43) Date de publication de la demande: 06.04.2011
(73) Titulaire: Microwave Vision, 91140 Villebon Sur Yvette (FR)
(72) Inventeur: GARREAU, Philippe, 91540 Mennecy (FR); IVERSEN, Per, Marietta Georgia 30068 (US); DUCHESNE, Luc, 91470 Angervilliers (FR); GANDOIS, Arnaud, 91650 Breuillet (FR)
(74) Mandataire: Regimbeau
(86) Numéro de dépôt international: PCT/EP2009/057781
(87) Numéro de publication internationale: WO 2010/006891

(56) Documents cités:
- EP-A- 1 326 070
- FR-A- 2 858 855
- JP-A- 5 026 930
- JP-A- 2006 258 759

## Description

L'invention concerne le domaine des dispositifs pour la détermination d'au moins une grandeur associée au rayonnement électromagnétique d'un objet sous test.

Il a déjà été proposé, pour déterminer le diagramme de rayonnement d'un objet sous test, d'utiliser des dispositifs qui se présentent sous la forme d'un réseau de sondes réparties sur une arche circulaire, une portion d'arche, une sphère, une portion de sphère (calotte sphérique) ou une portion de cylindre (calotte cylindrique) placé autour de l'objet sous test à étudier ou encore sur une ligne ou un plan placé devant l'objet sous test à étudier.

On connaît ainsi des dispositifs de ce type qui comportent des moyens qui permettent à l'arche de sondes, à la portion d'arche, à la sphère ou à la portion de sphère et à l'objet sous test de tourner l'un par rapport à l'autre autour d'un axe qui correspond à un diamètre de l'arche ou de la sphère de façon à mesurer le rayonnement de l'objet sous test dans des plans successifs répartis autour de l'axe de rotation relatif de l'arche ou de la sphère et de l'objet sous test c'est-à-dire sur une sphère ou une portion de sphère entourant l'objet.

Il est également connu d'utiliser des réseaux de sondes en arche, portion d'arche ou portion de cylindre en déplaçant de façon relative l'objet sous test perpendiculairement par rapport au plan du réseau de sondes de façon à mesurer ainsi le rayonnement sur un cylindre ou une portion de cylindre entourant l'objet.

Il est aussi connu d'utiliser des réseaux de sondes en ligne en tournant de façon relative l'objet sous test autour d'un axe parallèle au réseau de sonde de façon à mesurer ainsi le rayonnement sur un cylindre entourant l'objet.

Il est aussi connu d'utiliser des réseaux de sondes en ligne ou en plan en déplaçant de façon relative l'objet sous test sur un plan parallèle au réseau de sonde de façon à mesurer ainsi le rayonnement sur un plan devant l'objet.

On connaît de l'état de la technique le document FR 2858855 dans lequel le support d'un objet sous test est mobile en rotation autour du centre géométrique d'un réseau de sondes. On connaît également les documents JP2006258759, JP05026930, et EP1326070, décrivant des moyens de déplacement de l'objet sous test selon une ou deux directions rectilignes par rapport à une ou plusieurs sondes.

Ces dispositifs à réseau de sondes en arche, sphère, ligne ou plan présentent toutefois, qu'ils soient utilisés pour des mesures en coordonnées sphériques, des mesures en coordonnées cylindriques ou des mesures en coordonnées planaires, des limitations liées au pas de mesure discrétisé imposé par la disposition des sondes en réseau.

En effet, le nombre de points de mesure nécessaire pour mesurer une antenne à une fréquence donnée est lié directement à la taille de la source rayonnante et à la longueur d'onde à la fréquence de mesure (λ). Par exemple, pour des mesures en géométrie sphérique ou cylindrique, différents critères d'échantillonnage existent pour déterminer le nombre de points de mesure nécessaires le long de l'arche, de la portion d'arche, sur la sphère, la portion de sphère ou la portion de cylindre. Le plus connu est donné par la distance minimum égale à λ/2 entre les points d'échantillonnage sur la sphère minimum entourant la source, sphère minimum de diamètre D et dont le centre coïncide avec le centre du réseau. Ce qui correspond à un espacement angulaire entre les sondes de mesure du réseau égal à λ/D. De même pour des mesures en géométrie planaire, le critère d'échantillonnage est donné par la distance minimum égale à λ/2 entre tes points d'échantillonnage sur un plan devant la source. Ce qui correspond à un espacement entre les sondes de mesure du réseau égale à λ/2.

L'utilisation d'un réseau de sondes dont la taille, le nombre et l'espacement des sondes de mesure sont physiquement limités impose alors soit, pour une fréquence donnée, des contraintes sur les dimensions de l'objet sous test dont on veut mesurer le champ , soit pour des dimensions de l'objet sous test données, des contraintes sur la fréquence de mesure maximale possible.

Pour pallier ces inconvénients, on a alors proposé dans le cadre des mesures avec des arches de sondes un dispositif comprenant des moyens autorisant, par rotation autour d'un axe, le basculement relatif du réseau de sondes et de l'objet sous test pour décaler angulairement l'un par rapport à l'autre le réseau de sondes de l'objet sous test et permettre ainsi des mesures selon plusieurs positions angulaires relatives du réseau de sondes et de l'objet sous test.

De cette façon, on multiplie pour chaque position relative du réseau de sondes et de l'objet sous test le nombre de points de mesure dans le plan de l'arche. Par conséquent, pour des dimensions de l'objet à mesurer données, cela permet d'augmenter la fréquence maximale de mesure possible. De même pour une fréquence de mesure donnée, cela permet d'augmenter les dimensions de l'objet sous test observé dans le plan de l'arche.

Un but de l'invention est de proposer un dispositif pour positionner relativement le réseau de sondes et l'objet sous test adapté pour permettre une multiplication encore plus importante du nombre de points de mesure échantillonnés.

Un autre but de l'invention est de proposer un dispositif pour positionner relativement le réseau de sondes et l'objet sous test permettant d'élargir le domaine d'utilisation d'un réseau de sondes donné notamment en termes de taille d'objet dont on peut déterminer le diagramme de rayonnement tout en conservant une capacité d'échantillonnage illimitée.

Un autre but de la présente invention est de proposer un dispositif pour positionner relativement le réseau de sondes et l'objet sous test permettant la mesure du rayonnement d'objets aux dimensions importantes à des fréquences plus élevées et avec un nombre de sondes réduit.

Un autre but encore de la présente invention est de proposer un dispositif pour positionner relativement le réseau de sondes et l'objet sous test simple à mettre en oeuvre et adapté pour être utilisé quelle que soit la forme du réseau de sondes du dispositif de mesure.

Ces buts sont atteints selon l'invention grâce à un dispositif pour positionner relativement un réseau de sondes électromagnétiques et un objet sous test caractérisé en ce qu'il comprend des moyens pour le déplacement relatif de l'objet sous test et du réseau de sondes électromagnétiques selon au moins deux degrés de liberté, ce déplacement relatif permettant de multiplier les points de mesures selon ces deux degrés de liberté afin de réaliser un sur-échantillonnage spatial au moyen du réseau de sondes lors d'une mesure du champ rayonné autour ou devant l'objet.

Avantageusement notamment, les moyens pour le déplacement relatif de l'objet sous test et du réseau de sondes électromagnétiques présentent un troisième degré de liberté qui peut être utilisé pour compléter le sur échantillonnage ou pour présenter l'objet sous différentes facettes.

Dans un mode de réalisation notamment, le dispositif comprend des moyens de glissement destinés à déplacer l'un ou l'autre de l'objet ou du réseau de sondes selon au moins une direction de glissement et des moyens de rotation relative de l'objet sous test et du réseau de sondes autour d'un axe de rotation principal.

Les moyens de rotation peuvent être désolidarisés des moyens de glissement.

En variante, il peut être prévu que les moyens de glissement et les moyens de rotation soient disposés l'un sur l'autre.

D'autres caractéristiques, buts et avantages de l'invention apparaîtront à la lecture de la description détaillée qui va suivre, laquelle est purement illustrative et non limitative et doit être lue en regard des dessins annexés sur lesquels:
- la figure 1 illustre un dispositif pour la détermination du rayonnement électromagnétique d'un objet sous test comprenant un dispositif pour positionner relativement un réseau de sondes électromagnétiques et un objet sous test;
- La figure 2 est une représentation schématique d'un mode de réalisation possible du dispositif pour positionner relativement le réseau de sondes électromagnétiques et l'objet sous test de la figure 1;
- Les figures 3a et 3b, 4 et 5 sont des représentations schématiques d'autres modes de réalisations possibles du dispositif pour positionner relativement le réseau de sondes électromagnétiques et l'objet sous test de la figure 1.

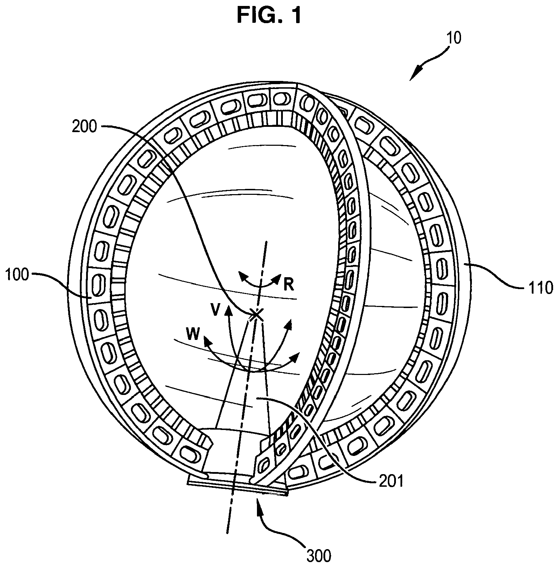

On a représenté sur la figure 1 un dispositif de mesure 10 comprenant principalement un réseau d'antennes de mesure 100 pour déterminer le diagramme de rayonnement d'un objet sous test 200 schématisé par une croix.

Il est par ailleurs prévu un dispositif 300 pour positionner de façon relative le réseau d'antennes de mesure 100 et l'objet sous test 200.

Le réseau d'antennes de mesures 100 aussi appelées sondes électromagnétiques est réparti sur une sphère 110.

Il est à noter qu'un réseau 100 se définit comme une série de n antennes de mesure, n étant supérieur ou égal à 2.

De préférence, ce réseau 100 combine, sur la sphère 110, plusieurs séries de sondes électromagnétiques fonctionnant à des fréquences différentes pour élargir la bande de fonctionnement du dispositif de mesure 10.

On peut ainsi citer comme exemple non limitatif un réseau 100 combinant deux séries de sondes électromagnétiques de manière à réaliser des mesures couvrant la bande de fréquence 0.4GHz à 18GHz.

On a représenté également un support 201 destiné à porter l'objet 200 dont on cherche à connaître le comportement électromagnétique.

Ce support 201 est essentiellement un mât qui s'étend depuis le dispositif de positionnement 300 jusqu'à proximité du centre géométrique de la sphère 110.

L'objet 200 est placé sur le support pour définir sa position azimutale et permettre de placer ce dernier dans la région du centre de la sphère 110 du réseau de sondes électromagnétiques 100.

Sur la figure 1, le réseau sphérique de sondes électromagnétiques est fixe tandis que le mât 201 est placé sur le dispositif 300 de positionnement lui permettant de se déplacer de façon relative par rapport au réseau sphérique 100.

### 1. Dispositif pour positionner relativement le réseau sphérique de sondes électromagnétiques et l'objet sous test

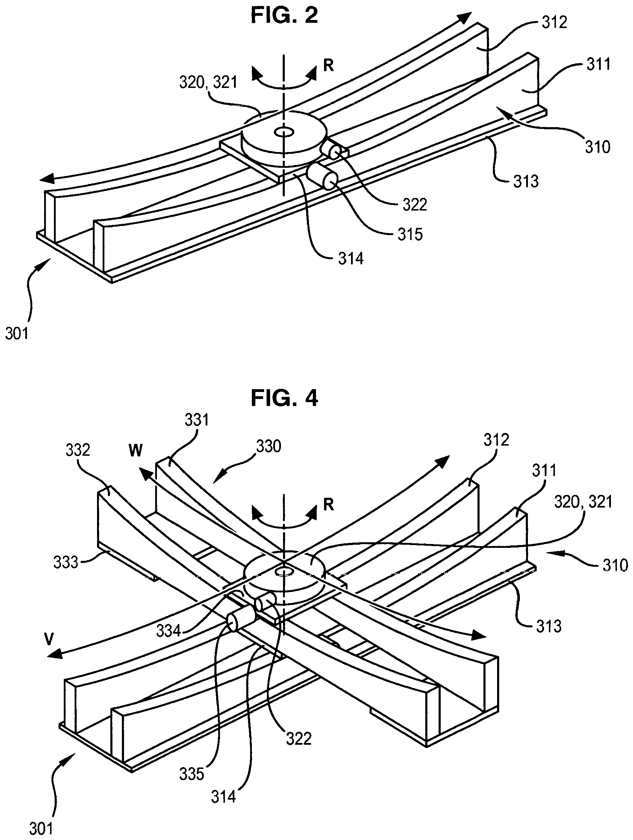

Ce dispositif 300 pour positionner relativement le réseau sphérique de sondes électromagnétiques et l'objet sous test 200 est illustré plus en détails sur les figures 2, 3, 4 et 5.

Dans la variante de la figure 2, ce dispositif comprend un rail de guidage 301 en arc de cercle qui permet un glissement relatif de l'objet sous test 200 et du réseau de sondes 100 destinés à déplacer l'un ou l'autre de l'objet 200 ou du réseau de sondes 100 selon au moins une direction de glissement appartenant à un plan diamétral du réseau de sondes 100. Ce rail de guidage 301 en arc de cercle porte en outre des moyens de rotation 320,avec en particulier un support 321, qui sont le cas échéant désolidarisables du rail 301 et pivotent axialement sur eux-mêmes et permettent ainsi la rotation relative de l'objet sous test 200 et du réseau de sondes 100 autour d'un axe de rotation principale perpendiculaire à la direction de glissement.

Les moyens de glissement 301 qui constituent l'arc de guidage sont avantageusement choisis pour décaler angulairement l'objet sous test 200 du réseau de sondes sphérique 100 l'un par rapport à l'autre.

Plus précisément, ils permettent comme illustré sur la figure 1 de faire glisser l'objet sous test 200 dans un plan diamétral du réseau sphérique de sondes 100 autour du centre géométrique de la sphère.

Le rail de guidage 301 comprend deux parois de guidage 311,312 parallèles s'étendant suivant la direction de glissement. Ces parois 311,312 constituent des moyens de guidage 310 et sont disposées sur une embase 313 destinée à maintenir l'écartement et l'inclinaison des parois 311,312.

Il est également prévu une palette de glissement 314 qui porte les moyens de rotation 320 et qui permet de déplacer l'objet sous test 200 le long des moyens de guidage 310 et à le fixer dans une position réglable le long de ceux-ci.

Ces parois de guidage 311,312 présentent un profil curviligne adapté pour permettre un déplacement angulaire de l'objet sous test 200 autour du centre géométrique de la sphère.

Dans une variante de réalisation des moyens de guidage, les parois 311 et 312 peuvent être avantageusement remplacées par une surface de glissement concave recevant une surface convexe supportant la palette de glissement 314.

Les moyens de glissement comprennent, en outre, des moyens 315 aptes à entraîner en déplacement sur le rail de guidage 301 la palette de glissement 314 sur laquelle repose l'objet sous test 200 suivant la direction de glissement vers la position désirée.

Par exemple, ces moyens d'entraînement 315 peuvent comprendre des systèmes d'engrenage, de crémaillère, de vis sans fin, de courroie crantée ou autres associés à une motorisation électrique pour déplacer l'objet sous test 200 le long des parois de guidage 311,312.

Par ailleurs, les moyens de rotation 320 relative de l'objet sous test 200 et du réseau de sondes 100, quant à eux, sont disposés sur la palette de glissement 314 et libres en rotation par rapport à ladite palette 314.

Les moyens de rotation 320 relative de l'objet sous test 200 et du réseau de sondes 100 comprennent un support 321 destiné à recevoir l'objet sous test 200 et des moyens aptes à entraîner ledit support 321 autour de son axe de rotation principale.

Ce support 321 entraîne ainsi l'objet sous test 200 pendant les mesures du réseau de sondes électromagnétiques 100 pour qu'il décrive une rotation sur lui-même. Des moyens d'entraînement 322 de type à engrenage, à courroie crantée, à vis sans fin, à cage d'écureuil ou autres sont prévus à cet effet au niveau des moyens de rotation 320.

Comme on l'aura compris, dans la variante de réalisation qui vient d'être décrite, il peut être prévu que l'objet sous test 200 est mobile et placé sur le dispositif de positionnement 300 tandis que le réseau de sondes 100 reste fixe. L'inverse est également possible, le réseau pouvant être mobile est positionné grâce au dispositif 300, tandis que l'objet sous test est fixe.

Dans une variante de réalisation du dispositif, les moyens de rotation 320 relative de l'objet sous test 200 et du réseau de sondes 100 peuvent être désolidarisés de la palette de glissement 314 et positionnés sur un socle fixe placé à côté des moyen de glissement 301 ou encore sous les moyens de glissement. Dans le cas où les moyens de rotation 320 sont placés sur un socle fixe sous les moyens de glissement 301, la palette 314 est adaptée pour pouvoir laisser déboucher le support 321 destiné à recevoir l'objet sous test 200 avec des moyens aptes à entraîner ledit support 321 autour de son axe de rotation principale. Dans cette variante de réalisation, l'axe de rotation principale du support 301 de l'objet sous test 200 reste fixe tandis que la sphère 110 du réseau de sondes 100 est montée sur la palette de glissement 314 et est mobile lui permettant de se déplacer de façon relative par rapport à l'objet sous test 200. L'inverse est également possible, l'objet sous test 200 étant monté sur la palette de glissement, tandis que le réseau de sondes est monté rotatif autour d'un axe 301 indépendant (c'est-à-dire désolidarisé).

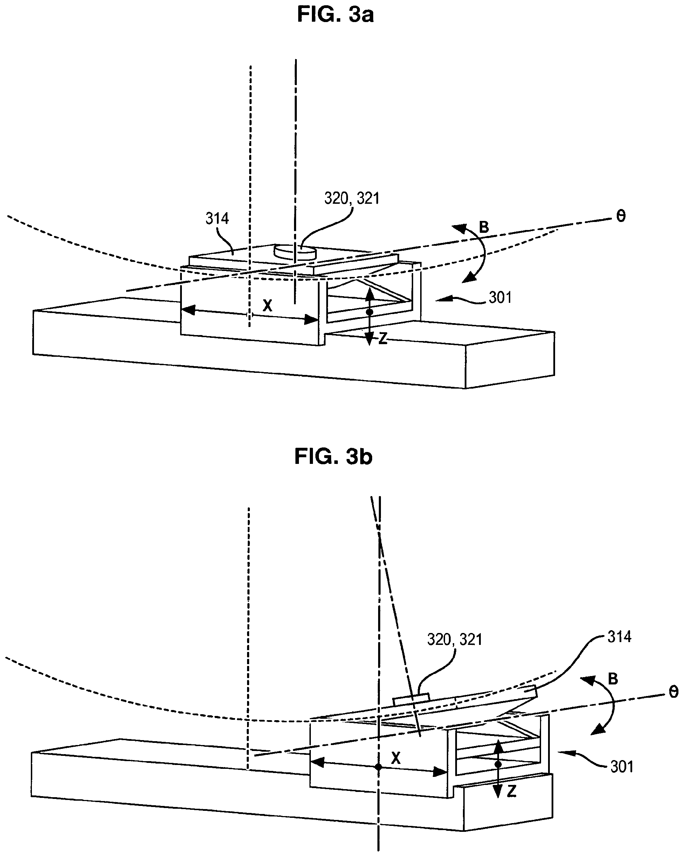

Par ailleurs, selon une autre variante de réalisation du dispositif 300 et tel qu'illustré sur les figures 3a et 3b, les moyens de glissement 301 (et/ou de rotation) relatif de l'objet sous test 200 et du réseau de sondes 100 peuvent être réalisés au moyen de 3 mouvements mécaniques indépendants (jeux de vérins et/ou de moteurs électriques) : une translation suivant l'axe X, une seconde translation suivant l'axe Z et une rotation suivant l'axe θ. En effet, la combinaison des translations suivant les axes X et Z va permettre d'effectuer une course curviligne équivalente à celle réalisée avec les moyens de glissement 301 de la figure 2 tandis que la rotation suivant l'axe θ va permettre de maintenir une orientation de la palette 314 équipée de ses moyens de rotation 320, l'axe de rotation du support 321 restant perpendiculaire à la course curviligne du glissement. Cette variante de réalisation a l'avantage d'être adaptable à tout rayon de sphère 110 du réseau de sonde 100 et offre la possibilité de pouvoir programmer numériquement la course curviligne du glissement. Elle permet également d'effectuer en temps réel une correction de trajectoire au moyen par exemple de laser mesurant en temps réel la position du mât 201 ou celle de l'objet sous test 200.

Par ailleurs, selon une autre variante de réalisation du dispositif 300, les moyens de glissement 301 relatif de l'objet sous test 200 et du réseau de sondes 100 sont prévus pour déplacer l'un ou l'autre de l'objet 200 ou du réseau de sondes 100 selon deux directions de glissement perpendiculaires appartenant à un ou plusieurs plans du réseau de sondes 100 sur lesquels sont disposés les moyens de rotation 320 relative de l'objet sous test 200 et du réseau de sondes 100 autour d'un axe de rotation principale perpendiculaire aux directions de glissement.

Tel qu'illustré sur la figure 4, les moyens de glissement 301 peuvent alors prendre la forme d'un premier moyen de guidage 310 définis par les deux parois de guidage 311,312 parallèles s'étendant suivant une première direction de glissement sur lesquels est disposée la première palette de glissement 314 et un second moyen de guidage 330 (parois 331,332) s'étendant suivant une seconde direction de glissement perpendiculaire à la première sur lesquels est disposée une seconde palette de glissement 334.

Les premier et second ensembles sont similaires aux moyens de glissement 301 décrit en référence à la figure 2.

Dans une variante de réalisation encore, on combine en les juxtaposant un premier et second ensembles similaires aux moyens de glissement 301 décrit en référence à la figure 3.

L'agencement de la figure 4 est précisé ci dessous.

Sur la première palette de glissement 314 vient se placer le second rail 330. Ainsi, la première palette de glissement 314 du premier ensemble permet de déplacer le second ensemble suivant la première direction de glissement et de le fixer dans une position réglable le long du moyen de guidage 310.

Ces moyens de glissement 301 sont adaptés pour permettre deux déplacements angulaires perpendiculaires de l'objet sous test 200 afin qu'il décrive le contour d'une sphère centrée sur le centre géométrique du réseau sphérique de sondes électromagnétiques 100.

Sur la seconde palette de glissement 334 vient se fixer le support des moyens de rotation 320 permettant la rotation de l'objet sous test 200 par rapport à la sphère du réseau de sondes 100.

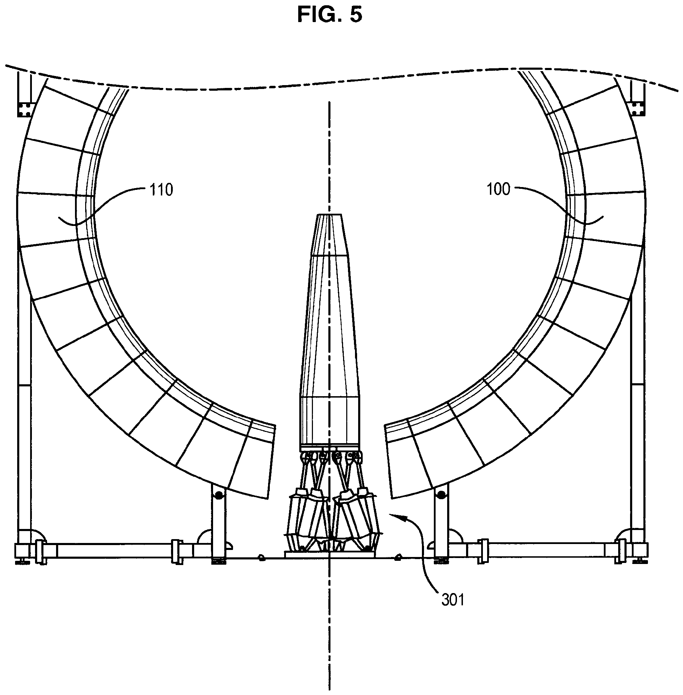

Par ailleurs, selon une autre variante de réalisation du dispositif 300 et tel qu'illustré sur la figure 5, les moyens de glissement 301 relatif de l'objet sous test 200 et du réseau de sondes 100 peuvent être réalisés au moyen d'un ensemble de 6 vérins mécaniques aussi appelé hexapode permettant de réaliser une course curviligne équivalente à celle réalisée avec les moyens de glissement 301 de la figure 4 tout en maintenant une orientation de l'axe des moyens de rotation 320 perpendiculaire à la course curviligne du glissement. Cette variante de réalisation a l'avantage d'être complètement reconfigurable par rapport à tout rayon de sphère 110 du réseau de sonde 100. De plus, cette solution permet aussi un réglage aisé de la hauteur du mât 201 sur lequel est placé l'objet sous test. De plus, elle permet d'effectuer de multiples variantes de courses curvilignes et offre la possibilité de pouvoir programmer numériquement les courses curvilignes du glissement ainsi que de pouvoir effectuer en temps réel une correction de trajectoire au moyen par exemple de laser mesurant en temps réel la position du mât 201 ou celle de l'objet sous test 200.

Par ailleurs, dans une variante de réalisation des dispositifs 300 présenté sur les figures 1 à 4, on prévoit que le réseau de sondes 100 soit mobile et placé sur le dispositif de positionnement 300 n'intégrant pas les moyens de rotation 320 tandis que l'objet sous test 200 est placé sur le support 321 sur les moyens de rotation 320 désolidarisés des moyens de glissement 301 et conserve un axe de rotation principale fixe.

Par ailleurs, dans une variante de réalisation du dispositif 300 présenté sur les figures 1 à 4, on prévoit que l'objet sous test 200 soit mobile et placé sur le dispositif de positionnement 300 n'intégrant pas les moyens de rotation 320 tandis que le réseau de sondes 100 est placé sur le support 321 sur les moyens de rotation 320 désolidarisés des moyens de glissement 301 et conserve un axe de rotation principal fixe.

### 2. Suréchantillonnage en trois dimensions

Le dispositif 300 pour positionner de façon relative l'objet sous test 200 et le réseau de sondes électromagnétiques 100 permet avantageusement de réaliser un suréchantillonnage en trois dimensions des mesures de champ rayonné effectuées.

Chaque mouvement de glissement sur les rails 310, 330 permet avantageusement de multiplier les points de mesure de rayonnement autour de l'objet et ainsi de réaliser un échantillonnage angulaire accru.

En effet, suite au glissement de l'objet sous test sur les rails 310, 330 d'une position initiale vers une position finale, on peut décaler angulairement le réseau de sondes électromagnétiques 100 par rapport à l'objet sous test 200 ou inversement et balayer ainsi plusieurs positions relatives du réseau de sondes 100 par rapport à l'objet sous test 200.

Ainsi, pour chaque plan de mesure de rayonnement, il est possible d'effectuer plusieurs séries de points de mesure consécutifs correspondant aux différents décalages angulaires relatifs du réseau de sondes électromagnétiques 100 et de l'objet sous test 200.

Dans le cas d'un réseau sphérique de sondes électromagnétiques 100, ces décalages angulaires relatifs du réseau de sondes électromagnétiques 100 et de l'objet sous test 200 sont inférieurs au pas angulaire du réseau de sondes 100.

Les moyens de glissement 301 précédemment décrits pour permettre deux déplacements angulaires perpendiculaires de l'objet sous test 200 et du réseau de sondes électromagnétiques 100 offrent la possibilité de multiplier les points de mesure de champ rayonné en coordonnées sphériques avec un réseau sphérique de sondes électromagnétiques 100 et de réaliser un suréchantillonnage en élévation.

Les moyens de rotation 320 selon un axe principal perpendiculaire aux directions de glissement, quant à eux, permettent une multiplication des points de mesure dans le plan azimutal ou un plan parallèle à celui ci.

Ainsi, vient s'associer un suréchantillonnage azimutal au suréchantillonnage en élévation offrant la possibilité de réaliser une multiplication du nombre de points de mesure échantillonnés en trois dimensions sur l'ensemble de la sphère de mesure entourant l'objet sous test 200.

### 3. Autres géométries

L'invention a été en l'occurrence décrite dans le cas de réseaux de sondes sphériques. Elle s'applique bien entendu à toute autre configuration de réseaux de sondes et notamment dans le cas de réseaux linéaires ou planaires, de réseaux supportés par une arche circulaire ou portion d'arche circulaire ou encore de réseaux supportés par une calotte sphérique ou cylindrique.

Par exemple, dans le cas d'un réseau de sondes linéaires, il est alors prévu un dispositif 300 pour positionner le réseau de sondes 100 ou l'objet sous test 200 comportant des moyens de glissement 301 destinés à permettre un glissement linéaire dans le cadre de mesures de champ rayonné en coordonnées planaires.

Ces moyens de glissement 301 sont avantageusement choisis pour décaler le réseau de sondes 100 et l'objet sous test 200 l'un par rapport à l'autre avec un décalage supérieur ou inférieur au pas du réseau de sondes 100 et pour permettre des mesures selon plusieurs positions relatives du réseau de sondes 100 et de l'objet sous test 200.

Les moyens de guidage 310 peuvent prendre alors la forme de deux rails 311,312 de profil rectiligne sur lesquels vient se placer transversalement la palette de positionnement 314 apte à recevoir et à fixer dans une position réglable le long de ceux ci l'objet sous test 200 ou le réseau de sondes électromagnétiques 100.

Le mouvement de glissement du réseau de sondes électromagnétiques 100 linéaire sur les rails 311,312 permet avantageusement de multiplier, dans un plan de mesure de rayonnement, les points de mesure de rayonnement mais aussi d'agrandir la zone géométrique de mesure de l'objet sous test 200 couverte.

En effet, le mouvement de glissement avec un décalage supérieur au pas du réseau de sondes 100 permet de couvrir, dans un plan de mesure de rayonnement, une zone géométrique de l'objet sous test 200 différente de celle précédemment étudiée avant le glissement.

Dans un exemple de réalisation, le dispositif 300 positionnant le réseau de sonde 100 est translaté perpendiculairement au réseau de sondes 100 devant l'objet sous test 200 placé sur un support 201 fixe pour réaliser des mesures sur un plan devant l'objet sous test.

Dans un autre exemple de réalisation, le dispositif 300 positionnant le réseau de sonde 100 est placé devant l'objet sous test 200, lui-même fixé sur un mât 201 monté sur un support 321 entrainé par des moyens de rotation 320 relative de l'objet sous test par rapport au réseau de sondes autour d'un axe de rotation parallèle au réseau de sondes pour réaliser des mesures sur un cylindre entourant l'objet sous test.

Dans un autre exemple de réalisation, l'ensemble du dispositif 300 positionnant le réseau de sonde 100 subit une rotation grâce aux moyens de rotation 320 devant l'objet sous test 200 placé sur un support 201 fixe pour réaliser des mesures sur un disque en géométrie polaire devant l'objet sous test.

Dans une autre variante de réalisation, on prévoit un réseau de sondes 100 réparties sur un support plan.

Les moyens de glissement 301 sont alors similaires aux moyens de glissement décrits en référence avec la figure 4 à la différence de la forme du profil des rails des deux ensembles utilisés.

Le couple de rails de chaque ensemble présente un profil rectiligne permettant aux moyens de glissement 301 de déplacer linéairement le réseau de sondes 100 ou l'objet sous test 200 dans les deux directions perpendiculaires formant le plan du réseau de sondes.

La description précédente se transpose bien entendu au cas pour des mesures en géométrie sphérique ou cylindrique.

En conclusion, l'homme de l'art appréciera un dispositif de positionnement 300 relatif du réseau de sondes 100 et de l'objet sous test 200 permettant une multiplication des points de mesures effectués quelle que soit la forme du réseau de sondes 100 et, par conséquent, dans le cas d'un réseau sphérique de sondes 100 l'opportunité de pouvoir effectuer un suréchantillonnage en trois dimensions sur l'ensemble d'une sphère de mesure entourant l'objet sous test 200.
Par ailleurs, l'homme de l'art appréciera également un dispositif de positionnement 300 relatif du réseau de sondes 100 et de l'objet sous test 200 permettant d'explorer une plus grande zone géométrique de mesure de l'objet sous test 200 étudiée par rapport au réseau de sondes 100 utilisé.

## Revendications

1. Dispositif (300) pour positionner relativement un réseau de sondes électromagnétiques (100) et un objet sous test (200), comprenant des moyens (301) de glissement pour le déplacement relatif de l'objet sous test (200) et du réseau de sondes électromagnétiques (100),
lesdits moyens (301) de glissement comprenant un premier ensemble de guidage s'étendant suivant une première direction de glissement sur lesquels est disposée une première palette de glissement (314) et un second ensemble de guidage s'étendant suivant une seconde direction de glissement perpendiculaire à la première sur lesquels est disposée une seconde palette de glissement (334) destinée à recevoir l'un ou l'autre de l'objet sous test (200) ou du réseau de sondes électromagnétiques (100),
le premier ensemble et le deuxième ensembles de glissement étant chacun configuré pour réaliser une course curviligne de glissement,
ce déplacement relatif permettant de multiplier les points de mesures afin de réaliser un suréchantillonnage spatial au moyen du réseau de sondes (100) lors d'une mesure du champ rayonné autour ou devant l'objet (200).

2. Dispositif selon la revendication 1, **caractérisé en ce qu'**il comprend des moyens de rotation (320) relative de l'objet sous test (200) et du réseau de sondes (100) autour d'un axe de rotation principal.

3. Dispositif selon la revendication 2, **caractérisé en ce que** les moyens de rotation (320) sont désolidarisés des moyens de glissement (301),

4. Dispositif selon la revendication 2, **caractérisé en ce que** les moyens de glissement (301) et les moyens de rotation (320) sont superposés les uns aux autres.

5. Dispositif selon la revendication 4, dans lequel les moyens de rotation (320) sont fixés sur la seconde palette de glissement.

6. Dispositif selon l'une des revendications 1 à 5, dans lequel
- le réseau de sondes électromagnétiques (100) étant sphérique,
- les moyens de glissement (301) sont adaptés pour permettre deux déplacements angulaires perpendiculaires de l'objet sous test (200) afin qu'il décrive le contour d'une sphère centrée sur le centre géométrique dudit réseau sphérique de sondes électromagnétiques (100).

7. Dispositif selon l'une des revendications 1 à 6, dans lequel chaque ensemble de guidage comprend un rail de guidage (301, 330) comprenant des parois de guidage (311, 312, 331, 332) ayant un profil curviligne.

8. Dispositif selon l'une des revendications 1 à 7, **caractérisé en ce qu'**il comporte un jeu de vérins et/ou de moteurs électriques aptes à réaliser ensemble les mouvements de glissement et/ou de rotation.

9. Dispositif selon la revendication 8, **caractérisé en ce qu'**il comporte des moyens pour programmer numériquement les mouvements de glissement et/ou de rotation

10. Dispositif selon la revendication 8, **caractérisé en ce qu'**il comprend un ensemble de vérins disposés en hexapode.

11. Dispositif selon l'une des revendications 8 à 10, **caractérisé en ce qu'**il comporte des moyens de détection de type optiques pour la correction en temps réel du mouvement.

12. Dispositif selon l'une des revendications 1 à 11, apte à réaliser un décalage angulaire relatif du réseau de sondes électromagnétiques (100) et de l'objet sous test (200) inférieur au pas angulaire du réseau de sondes (100).

13. Dispositif pour la détermination d'au moins une caractéristique de rayonnement électromagnétique d'un objet sous test (200), comprenant
un réseau de sondes électromagnétiques (100), et **caractérisé en ce qu'**il comprend en outre
un dispositif (300) pour positionner de façon relative l'objet sous test (200) et ledit réseau de sondes (100) selon l'une des revendications 1 à 12.

14. Dispositif selon la revendication 13, **caractérisé en ce que** le réseau de sondes électromagnétiques (100) est un réseau de sondes de forme sphérique.

15. Dispositif selon la revendication 13, **caractérisé en ce que** le réseau de sondes électromagnétiques (100) est un réseau de sondes de forme d'arche circulaire ou portion d'arche circulaire, ou de forme de calotte sphérique.

## Patentansprüche

1. Vorrichtung (300) für die relative Positionierung eines Netzwerks von elektromagnetischen Sonden (100) und eines Prüfobjekts (200), die Schiebemittel (301) für die relative Verschiebung des Prüfobjekts (200) und des Netzwerks von elektromagnetischen Sonden (100) umfasst,
wobei die Schiebemittel (301) eine erste Führungsanordnung umfassen, die sich in einer ersten Schieberichtung erstreckt, auf denen eine erste Schiebepalette (314) angeordnet ist, und eine zweite Führungsanordnung, die sich in einer zweiten Schieberichtung senkrecht zur ersten erstreckt, auf denen eine zweite Schiebepalette (334) angeordnet ist, die das eine oder das andere der Prüfobjekt (200) oder des Netzwerks von elektromagnetischen Sonden (100) aufnehmen soll,
wobei die erste und die zweite Schiebeanordnung jeweils für die Durchführung eines krummlinigen Schiebelaufs konfiguriert ist,
wobei diese relative Verschiebung ermöglicht, die Messpunkte zu multiplizieren, um bei einer Messung des gestrahlten Felds um oder vor dem Objekt (200) eine räumliche Überabtastung vermittels des Netzwerks von Sonden (100) durchzuführen.

2. Vorrichtung nach Anspruch 1, **dadurch gekennzeichnet, dass** sie Mittel zur relativen Drehung (320) des Prüfobjekts (200) und des Netzwerks von Sonden (100) um eine Hauptdrehachse umfasst.

3. Vorrichtung nach Anspruch 2, **dadurch gekennzeichnet, dass** die Drehmittel (320) von den Schiebemitteln (301) getrennt sind.

4. Vorrichtung nach Anspruch 2, **dadurch gekennzeichnet, dass** die Schiebemittel (301) und die Drehmittel (320) übereinander überlagert sind.

5. Vorrichtung nach Anspruch 4, wobei die Drehmittel (320) auf der zweiten Schiebepalette befestigt sind.

6. Vorrichtung nach einem der Ansprüche 1 bis 5, wobei
- das Netzwerk von elektromagnetischen Sonden (100) kugelförmig ist,
- die Schiebemittel (301) geeignet sind, um zwei senkrechte Winkelverschiebungen des Prüfobjekts (200) zu ermöglichen, damit es die Kontur einer Kugel beschreibt, die auf den geometrischen Mittelpunkt des kugelförmigen Netzwerks von elektromagnetischen Sonden (100) zentriert ist.

7. Vorrichtung nach einem der Ansprüche 1 bis 6, wobei jede Führungsanordnung eine Führungsschiene (301, 330) umfasst, die Führungswände (311, 312, 331, 332) mit einem krummlinigen Profil aufweist.

8. Vorrichtung nach einem der Ansprüche 1 bis 7, **dadurch gekennzeichnet, dass** sie einen Satz Arbeitszylinder und/oder Elektromotoren umfasst, die geeignet sind, gemeinsam Schiebe- und/oder Drehbewegungen auszuführen.

9. Vorrichtung nach Anspruch 8, **dadurch gekennzeichnet, dass** sie Mittel zur digitalen Programmierung der Schiebe- und/oder Drehbewegungen umfasst.

10. Vorrichtung nach Anspruch 8, **dadurch gekennzeichnet, dass** sie einen Satz Arbeitszylinder umfasst, die nach einem Hexapod angeordnet sind.

11. Vorrichtung nach einem der Ansprüche 8 bis 10, **dadurch gekennzeichnet, dass** sie optische Mittel von optischen Typ für die Korrektur der Bewegung in Echtzeit umfasst.

12. Vorrichtung nach einem der Ansprüche 1 bis 11, die geeignet ist, eine relative Winkelverschiebung des Netzwerks von elektromagnetischen Sonden (100) und des Prüfobjekts (200) durchzuführen, die geringer als der Winkelschritt des Netzwerks von Sonden (100) ist.

13. Vorrichtung für die Bestimmung von zumindest einem Merkmal einer elektromagnetischen Strahlung eines Prüfobjekts (200), die Folgendes umfasst:
Netzwerk von elektromagnetischen Sonden (100), und **dadurch gekennzeichnet, dass** sie ferner umfasst
Vorrichtung (300) für die relative Positionierung des Prüfobjekts (200) und des Netzwerks von Sonden (100) nach einem der Ansprüche 1 bis 12.

14. Vorrichtung nach Anspruch 13, **dadurch gekennzeichnet, dass** das Netzwerk von elektromagnetischen Sonden (100) ein Netzwerk von kugelförmigen Sonden ist.

15. Vorrichtung nach Anspruch 13, **dadurch gekennzeichnet, dass** das Netzwerk von elektromagnetischen Sonden (100) ein Netzwerk von Sonden in Form eines Kreisbogens oder eines Abschnitts eines Kreisbogens oder einer Kugelhaubenform ist.

## Claims

1. A device (300) for the relative positioning of a network of electromagnetic probes (100) and an object under test (200), comprising sliding means (301) for the relative movement of the object under test (200) and network of electromagnetic probes (100),
the sliding means (301) comprising a first guide assembly extending in a first sliding direction on which a first sliding pallet (314) is arranged, and a second guide assembly extending in a second sliding direction perpendicular to the first on which a second sliding pallet (334) is arranged, intended to receive either the object under test (200) or the network of electromagnetic probes (100),
the first and second sliding assemblies each being configured to achieve curvilinear travel of sliding, this relative movement allowing multiplication of the measurement points to perform spatial oversampling by means of the probe network (100) when measuring the radiated field around or in front of the object (200).

2. The device according to claim 1, **characterized in that** it comprises means (320) for relative rotation of the object under test (200) and probe network (100) about a main axis of rotation.

3. The device according to claim 2, **characterized in that** the rotating means (320) are separate from the sliding means (301).

4. The device according to claim 2, **characterized in that** the sliding means (301) and the rotating means (320) are superimposed over each other.

5. The device according to claim 4, wherein the rotating means (320) is attached on the second sliding pallet.

6. The device according to any of claims 1 to 5, wherein
- the network of electromagnetic probes (100) being spherical,
- the sliding means (301) are adapted to allow two perpendicular angular movements of the object under test (200) so that it describes the contour of a sphere centred on the geometric centre of said spherical network of electromagnetic probes (100).

7. The device according to any of claims 1 to 6, wherein each guide assembly comprises a guide rail (301, 330) comprising guide walls (311, 312, 331, 332) having a curvilinear profile.

8. The device according to any of claims 1 to 7, **characterized in that** it comprises a set of cylinders and/or electric motors capable together of achieving the sliding and/or rotation movements.

9. The device according to claim 8, **characterized in that** it comprises means for digital programming of the sliding and/or rotation movements.

10. The device according to claim 8, **characterized in that** it comprises a set of cylinders with hexapod arrangement.

11. The device according to any of claims 8 to 10, **characterized in that** it comprises detection means of optical type for real-time correction of movement.

12. The device according to any of claims 1 to 11, capable of achieving relative angle offset of the network of electromagnetic probes (100) and the object under test (200) smaller than the angular pitch of the probe network (100).

13. A device for determining at least one characteristic of electromagnetic radiation of an object under test (200) comprising
a network of electromagnetic probes (100), and **characterized in that** it further comprises
a device (300) for relative positioning of the object under test (200) and said probe network (100) according to any of claims 1 to 12.

14. The device according to claim 13, **characterized in that** the network of electromagnetic probes (100) is a probe network of spherical shape.

15. The device according to claim 13, **characterized in that** the network of electromagnetic probes (100) is a probe network of circular arch or portion of circular arch shape, or of spherical cap shape.
